# EUROPÄISCHE PATENTSCHRIFT

(11) **EP 0 799 846 B1**
(45) Veröffentlichungstag und Bekanntmachung des Hinweises auf die Patenterteilung: **14.06.2000**
(21) Anmeldenummer: 97104685.9
(22) Anmeldetag: 19.03.1997
(51) Int. Cl.: C08G 59/14, C08G 59/30, C08G 59/40, H01B 3/40, C09K 21/14

(54) **Phosphormodifizierte Epoxid-harzmischungen aus Expoxid-harzen, phosphorhaltigen Verbindungen und einem Härter**
Phosphorus modified epoxy resin mixtures comprising epoxy resins, phosphorus-containing compounds and a curing agent
Mélange de résines époxy, modifiées par du phosphore contenant des résines époxy, des composés contenant du phosphore et un durcisseur

(30) Priorität: 01.04.1996 DE 19613065; 10.03.1997 DE 19709519
(43) Veröffentlichungstag der Anmeldung: 08.10.1997
(73) Patentinhaber: Clariant GmbH, 65929 Frankfurt am Main (DE)
(72) Erfinder: Hörold, Sebastian, Dr., 50374 Erftstadt (DE)

(56) Entgegenhaltungen:
- EP-A- 0 543 298
- DE-A- 2 652 007
- DE-A- 2 652 052
- DE-A- 4 308 185
- CHEMICAL ABSTRACTS, vol. 108, no. 18, 2.Mai 1988 Columbus, Ohio, US; abstract no. 151779, HARA, K E.A.: "Flame retardant polyester-epoxy adhesive compositions" XP002031294 & JP 62 218 465 A (TORAY INDUSTRIES)

## Beschreibung

Die vorliegende Erfindung betrifft phosphormodifizierte Epoxidharzmischungen aus Epoxidharzen, phosphorhaltigen Verbindungen und einem Härter, ein Verfahren zu ihrer Herstellung und ihre Verwendung. Diese Epoxidharzmischungen zeichnen sich durch ihre Flammwidrigkeit aus.

Epoxidharze werden heute zur Herstellung von Formmassen und Beschichtungen mit hohen thermischen, mechanischen und elektronischen Eigenschaften eingesetzt. Sie sind geeignet zum Verguß von elektrischen bzw. elektronischen Bauteilen und für Tränk- und Imprägnierprozesse. In der Elektrotechnik werden die verwendeten Epoxidharz-Formmassen überwiegend flammwidrig ausgerüstet.

Epoxidharz-Formmassen werden im allgemeinen mit bromhaltigen aromatischen Verbindungen, insbesondere Tetrabrombisphenol A, flammwidrig ausgerüstet. Werden ausschließlich bromierte Flammschutzmittel eingesetzt, so wird ein Bromgehalt von etwa 20 % benötigt, um ein Selbstverlöschen der Formmassen zu gewährleisten. Als Synergist wird häufig Antimontrioxid verwendet. Im Brandfall wird Bromwasserstoff freigesetzt, was zu Schäden durch Korrrosion führen kann. Unter ungünstigen Bedingungen können auch polybromierte Dibenzodioxine und Furane entstehen. Es besteht also ein Bedarf an Epoxidharz-Formmassen, die die geforderte Flammwidrigkeit ohne Zusatz bromierter Verbindungen erreichen.

Darüber hinaus muß sichergestellt sein, daß bei der Zersetzung unter Hitzeeinwirkung keine ökologisch oder toxikologisch bedenkliche Produkte auftreten können.

Zur flammwidrigen Ausrüstung von Epoxidharz-Formmassen wurden bereits Füllstoffe mit Löschwirkung wie Aluminiumoxidhydrat vorgeschlagen (DE 35 40 524 A1). Auch durch den Zusatz von Ammoniumpolyphosphat, gegebenenfalls in Kombination mit Aluminiumoxidhydrat, kann eine hinreichende Flammwidrigkeit erreicht werden. Anstelle von Ammoniumpolyphosphat kann auch roter Phosphor verwendet werden (DE 17 45 796 A1).

Nachteilig bei allen als Füllstoff vorliegenden Flammschutzmitteln ist, daß keine Transparenz der Materialien erhalten wird. Es wurden bereits zahlreiche flüssige phosphororganische Verbindungen als flammhemmende Kunststoffzusätze vorgeschlagen. Nachteilig bei diesen Systemen ist aber der ausgeprägte "Weichmachereffekt" dieser Zusätze. Bei gehärteten Epoxidharzen äußert sich der weichmachende Effekt in einer starken Herabsetzung der Glasübergangstemperatur.

In der Literatur sind phosphormodifizierte Epoxidharze, die durch Umsetzung von Polyepoxidverbindungen mit Anhydriden von Phosphonsäuren oder Phosphinsäuren erhalten werden und sich durch gute flammwidrige Eigenschaften auszeichnen (DE 43 08 185 A1), bekannt.

Die flammwidrige Ausstattung von Epoxidharzen mit epoxidfunktionellen Phosphonsäureestern ist bereits beschrieben (EP 0 384 939 A1). Nachteilig bei diesen Systemen ist der hohe Syntheseaufwand derartiger Phosphonsäureester.

Es besteht somit ein erheblicher Bedarf an flammwidrigen (Beschichtungs)Materialien auf der Basis von Epoxidharzen, die eine hohe Flammwidrigkeit aufweisen, ohne daß sie halogenhaltige Komponenten oder andere, ökologisch oder toxikologisch bedenkliche Produkte enthalten oder solche bei der Zersetzung unter Hitzeeinwirkung freisetzen.

Es war daher Aufgabe der Erfindung, flammwidrige (Beschichtungs)Materialien zur Verfügung zu stellen, die die vorgenannten Eigenschaften aufweisen. Darüber hinaus sollen diese auf einfache Art und Weise herstellbar sein und sich auf einfache Art und Weise anwenden lassen.

Die Erfindung betrifft somit eine flammwidrige Epoxidharzmischung aus Epoxidharzen, phosphorhaltigen Verbindungen und einem Härter, dadurch gekennzeichnet, daß sie phosphorhaltige Struktureinheiten der Formel I

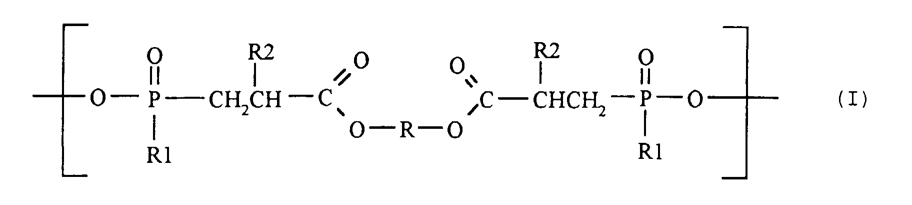

in der R1 eine Alkyl- oder Arylgruppe mit 1 bis 10 C-Atomen, R2 Wasserstoff oder eine Alkylgruppe mit 1 bis 4 C-Atomen und R eine Alkylen-, Cycloalkylen- oder Arylengruppe mit 2 bis 20 C-Atomen bedeutet, enthält.

Bevorzugt enthält die flammwidrige Epoxidharzmischung auf 100 Gewichtsteile Epoxidharz 10 bis 100 Gewichtsteile phosphorhaltiger Verbindungen der Formel I, wobei das Gesamtgewichtsverhältnis von Epoxidharz und phosphorhaltiger Verbindung nach Formel I zu Härter (1 bis 10) zu 1 beträgt.

Bevorzugt ist die flammwidrige Epoxidharzmischung halogenfrei.

Bevorzugt enthält die flammwidrige Epoxidharzmischung 5 bis 300 Gewichtsteile an phosphorfreien Epoxidharzen.

Bevorzugt enthält die flammwidrige Epoxidharzmischung 5 bis 300 Gewichtsteile an weiteren Inhalts- und/oder Füllstoffen.

Bevorzugt enthält die flammwidrige Epoxidharzmischung 0,5 bis 13 Gew.-% Phosphor, bezogen auf das Gesamtgewicht der flammwidrigen Epoxidharzmischung.

Besonders bevorzugt enthält die flammwidrige Epoxidharzmischung 1 bis 6 Gew.-% Phosphor, bezogen auf das Gesamtgewicht der flammwidrigen Epoxidharzmischung.

Bevorzugt enthält die flammwidrige Epoxidharzmischung einen Beschleuniger.

Die vorliegende Aufgabe wird ebenfalls gelöst durch ein Verfahren zur Herstellung von flammwidrigen Epoxidharzmischungen aus Epoxidharzen, phosphorhaltigen Verbindungen und einem Härter, welches dadurch gekennzeichnet ist, daß man
a) in einem ersten Reaktionsschritt eine Polyepoxidverbindung mit mindestens 2 Epoxidgruppen pro Molekül und ein 2,5-Dioxo-1,2-oxa-phospholan der allgemeinen Formel II 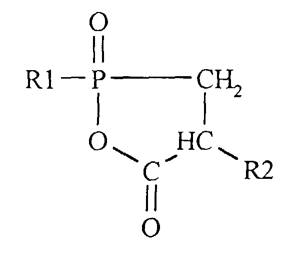 worin R1 und R2 die gleiche Bedeutung wie in Formel I haben, miteinander erwärmt, bis eine homogene Schmelze entstanden ist und
b) in einem zweiten Reaktionsschritt zu der Schmelze ein Diol der allgemeinen Formel HO - R - OH, worin R die gleiche Bedeutung wie in Formel I hat, zugibt, wobei
c) in einem dritten Reaktionsschritt aus dem 2,5-Dioxo-1,2-oxa-phospholan der homogenen Schmelze und dem dazugegebenen Diol HO - R - OH eine Diphosphinsäure der allgemeinen Formel III entsteht, welche direkt in die Polyepoxidverbindung einreagiert.

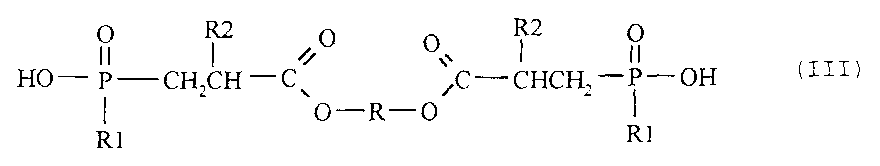

In einer anderen Ausführungsform ist das Verfahren dadurch gekennzeichnet, daß man
a) in einem ersten Reaktionsschritt ein 2,5-Dioxo-1,2-oxa-phospholan der allgemeinen Formel II mit einem Diol der allgemeinen Formel HO - R - OH, worin R die gleiche Bedeutung wie in Formel I hat, umsetzt, wobei eine Diphosphinsäure der allgemeinen Formel III entsteht, und dann
b) in einem zweiten Reaktionsschritt die Diphosphinsäure mit einer Polyepoxidverbindung mit mindestens zwei Epoxidgruppen pro Molekül umsetzt.

Bevorzugt erfolgen die Umsetzungen in einem Lösungsmittel.

Bevorzugt werden als aprotische, polare Lösungsmittel N-methylpyrrolidon, Dimethylformamid, Tetrahydrofuran, Dioxan, Dialkylether, Glykolether, Ketone und/oder Ester eingesetzt.

Geeignet sind ebenfalls Ethylenglykolether, Propylenglykolether, Butylenglykolether von Monoalkoholen mit ggf. verzweigten Alkylresten von 1 bis 6 C-Atomen sowie Ketone, wie Aceton, Methylethylketon, Methylisopropylketon, Methylisobutylketon, Cyclohexanon und ähnliche, aber auch Ester, wie Ethylacetat, Butylacetat, Ethylenglycolacetat und Methoxypropylacetat können eingesetzt werden.

Ebenfalls bevorzugt werden als Lösungsmittel halogenierte Kohlenwasserstoffe, aliphatische, cycloaliphatische und/oder aromatische Kohlenwasserstoffe, einzeln oder als Gemische, eingesetzt. Bevorzugt sind dabei Hexan, Heptan, Cyclohexan, Toluol sowie Dixylole.

Bevorzugt erfolgen die Umsetzungen bei Temperaturen zwischen -10 bis +200 °C.

Besonders bevorzugt erfolgen die Umsetzungen bei Temperaturen von 70 bis 130 °C.

Beim ersten Reaktionsschritt des einen erfindungsgemäßen Verfahrens werden eine Polyepoxidverbindung mit mindestens zwei Epoxidgruppen pro Molekül und ein 2,5-Dioxo-1,2-oxa-phospholan der allgemeinen Formel (II) , 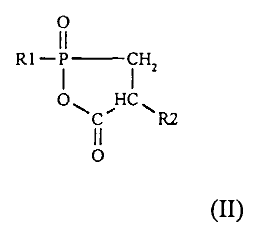 worin R1 und R2 die gleiche Bedeutung wie in Formel (I) haben, vorgelegt und erwärmt, bis eine homogene Schmelze entstanden ist. Anschließend wird ein Diol der allgemeinen Formel HO-R-OH, worin R die gleiche Bedeutung wie in Formel (I) hat, dazugetropft.

Alternativ kann das Diol auch direkt dazugegeben werden (Verfahrensvariante). Aus dem Diol und dem 2,5-dioxo-1,2-oxa-phospholan entsteht eine Diphosphinsäure nach Formel (I), die direkt in das Epoxidharz einreagiert.

Das verwendete Diol HO-R-OH kann beispielsweise Ethylenglycol, Propandiol, Butandiol, Cyclohexandiol, Resorcin oder Hydrochinon sein.

Die Herstellung des 2,5-Dioxo-1,2-oxaphospholans nach Formel (II) kann, wie in der DE 25 28 420 A1 beschrieben, aus Dihalogenphosphinen und einer ungesättigten Carbonsäure und anschließender Chlorabspaltung, beispielsweise durch Wasser oder Essigsäure, erfolgen.

Die erfindungsgemäß eingesetzten halogenfreien Epoxidverbindungen (im folgenden auch Polyepoxidverbindungen genannt) können gesättigt oder ungesättigt sowie aliphatisch, cycloaliphatisch, aromatisch und/oder heterocyclisch sein. Sie können weiterhin solche Substituenten enthalten, die unter den Mischungs- oder Reaktionsbedingungen keine störenden Nebenreaktionen verursachen, beispielsweise Alkyl- oder Arylsubstituenten, Ethergruppierungen oder ähnliche. Es können auch Gemische verschiedener Polyepoxidverbindungen verwendet werden. Das mittlere Molekulargewicht Mₙ dieser Polyepoxidverbindungen kann bis zu etwa 9000 betragen, liegt jedoch im allgemeinen bei etwa 150 bis 4000.

Beispielsweise handelt es sich bei diesen Polyepoxidverbindungen um Polyglycidylether auf Basis von mehrwertigen, vorzugsweise zweiwertigen Alkoholen, Phenolen, Hydrierungs-produkten dieser Phenole und/oder von Novolaken (Umsetzungsprodukte von ein- oder mehrwertigen Phenolen, wie Phenol und/oder Kresole, mit Aldehyden, insbesondere Formaldehyd in Gegenwart saurer Katalysatoren), die man in bekannter Weise, beispielsweise durch Umsetzung der jeweiligen Polyole mit Epichlorhydrin, erhält.
Als mehrwertige Phenole sind hier beispielsweise zu nennen: Resorcin, Hydrochinon, 2,2-Bis(4-hydroxyphenyl)propan (Bisphenol A), Isomerengemische des Dihydroxydiphenylmethans (Bisphenol F), 4,4'-Dihydroxydiphenylcyclohexan, 4,4'-Dihydroxy-3,3'-dimethyldiphenylpropan, 4,4-Dihydroxydiphenyl, 4,4'-Dihydroxybenzophenon, Bis(4-hydroxyphenyl)1,1-ethan,Bis(4-hydroxyphenyl)1,1'-isobutan, Bis(4-hydroxy-tert. -butylphenyl)2,2-propan, Bis(2-hydroxynaphthyl)methan, 1,5-Dihydroxynaphthalin, Tris(4-hydroxyphenyl)methan, Bis(4-hydroxyphenyl)1,1'-ether.

Bisphenol A und Bisphenol F sind hierbei bevorzugt.

Auch die Polyglycidylether von mehrwertigen aliphatischen Alkoholen sind als Polyepoxidverbindung geeignet. Als Beispiele derartiger mehrwertiger Alkohole seien 1,4-Butandiol, 1,6-Hexandiol, Polyalkylenglykole, Glycerin, Trimethylolpropan, Bis(4-hydroxycyclohexyl)2,2-propan und Pentaerythrit genannt.

Weiter kommen als Polyepoxidverbindungen auch (Poly)glycidester in Frage, die man erhält durch Umsetzung von Epichlorhydrin oder ähnlichen Epoxyverbindungen mit einer aliphatischen, cycloaliphatischen oder aromatischen Polycarbonsäure, wie Oxalsäure, Adipinsäure, Glutarsäure, Phthal-, Isophthal-, Terephthal-, Tetrahydrophthal- oder Hexahydrophthalsäure, 2,6-Naphthalindicarbonsäure und dimerisierte Fettsäuren. Beispiele hierfür sind Terephthalsäurediglycidylester und Hexahydrophthalsäurediglycidylester.

Polyepoxidverbindungen, die die Epoxidgruppen in statistischer Verteilung über die Molekülkette enthalten und die durch Emulsions-Copolymerisation unter Verwendung von olefinisch ungesättigten, diese Epoxidgruppen enthaltenden Verbindungen hergestellt werden können, wie z.B. Glycidylester der Acryl- oder Methacrylsäure, können in manchen Fällen vorteilhaft eingesetzt werden.

Weitere verwendbare Polyepoxidverbindungen sind solche auf der Basis heterocyclischer Ringsysteme, wie etwa Hydantoinepoxidharze, Triglycidylisocyanurat und/oder dessen Oligomere, Triglycidyl-p-aminophenol, Triglycidyl-p-aminodiphenylether, Tetraglycidyldiaminodiphenylmethan, Tetraglycidyldiaminodiphenylether, Tetrakis(4-glycidoxyphenyl)ethan, Urazolepoxide, Uracilepoxide, oxazolidinonmodifizierte Epoxidharze. Weiterhin Polyepoxide auf der Basis von aromatischen Aminen, wie Anilin, beispielsweise N,N-Diglycidylanilin, Diaminodiphenylmethan und N,N'-Dimethylaminodiphenylmethan oder -sulfon.

Weitere geeignete Polyepoxidverbindungen sind im "Handbook of Epoxy Resins" von Henry Lee und Kris Neville, McGraw-Hill Book Company, 1967, in der Monographie von Henry Lee "Epoxy Resins", American Chemical Society, 1970, in Wagner/Sarx, "Lackkunstharze", Carl Hanser Verlag (1971), 5. Auflage,174 ff, in der "Angew. Makromol. Chemie", Bd. 44 (1975), Seiten 151 bis 163, in der DE 27 57 733 A1 sowie in der EP 0 384 939 A1 beschrieben, auf die hiermit Bezug genommen wird.

Bevorzugt eingesetzte Polyepoxidverbindungen sind Bisglycidylether auf Basis von Bisphenol A, Bisphenol F und Bisphenol S, Umsetzungsprodukte dieser Bisphenole mit Epichlor(halogen)hydrin oder deren Oligomere, Polyglycidylether von Phenol/Formaldehyd- und/oder Kresol/Formaldehyd-Novolake sowie Diglycidylester der Phthal-, Isophthal-, Terephthal-, Tetrahydrophthal- und/oder Hexahydrophthalsäure sowie der Trimellithsäure, N-Glycidylverbindungen von aromatischen Aminen und heterocyclischen Stickstoffbasen, wie N,N-Diglycidylanilin, N,N,O-Triglycidyl-p-aminophenol, Triglycidylisocyanurat und N,N,N',N'-Tetraglycidylbis(p-aminophenyl)methan, Hydrantoin-Epoxidharze und Aracid-Epoxidharze sowie Di- und Polyglycidylverbindungen von mehrwertigen aliphatischen Alkoholen, wie 1,4-Butandiol, Trimethylolpropan und Polyalkylenglykolen. Des weiteren sind auch oxazolidinonmodifizierte Epoxidharze geeignet.

Derartige Verbindungen sind bereits bekannt (siehe: "Angew. Makromol. Chem.", Bd. 44 (1975), Seiten 151 bis 163, sowie US-PS 3 334 110); beispielhaft sei hierfür das Umsetzungsprodukt von Bisphenol-A-diglycidylether mit Diphenylmethandiisocyanat (in Gegenwart eines geeigneten Beschleunigers) genannt. Die Polyepoxidharze können bei der Herstellung der erfindungsgemäßen Überzugsmasse einzeln oder im Gemisch vorliegen.

Der Ausdruck "Härten", wie er hier gebraucht wird, bedeutet die Umwandlung der löslichen, schmelzbaren Polyepoxide in feste, unlösliche und unschmelzbare, dreidimensional vernetzte Produkte, in der Regel unter gleichzeitiger Formgebung, etwa zu Imprägnierungen, Beschichtungen und Verklebungen.

Als Härter können bespielsweise aliphatische, cycloaliphatische, aromatische und heterocyclische Amine, wie Bis(4-aminophenyl)methan, Anilin-Formaldehyd-Harze, Bis(4-aminophenyl)sulfon, Ethylendiamin, Propan-1,3-diamin, Hexamethylendiamin, Diethylentriamin, Triethylentetramin, 2,2,4-Trimethylhexan-1,6-diamin, m-Xylylendiamin, Bis(4-aminocyclohexyl)methan, 2,2-Bis(4-aminocyclohexyl)propan, 3-Aminomethyl-3,55-trimethylcyclohexylamin (Isophorondiamin), Polyamidoamine, Polyphenole, wie Hydrochinon, Resorcin, 2,2-Bis(4-hydroxyphenyl)propan (Bisphenol A) und Phenol-Aldehyd-Harze, Polycarbonsäuren und deren Anhydride, wie zum Beispiel Phtalsäureanhydrid, Tetrahydrophtalsäureanhydrid, Hexahydrophtalsäureanhydrid, Pyromellithsäuredianhydrid eingesetzt werden. Darüber hinaus können auch katalytisch wirkende Härtungsmittel wie Cyanguanidine oder Friedel-Crafts-Katalysatoren wir Bortrifluorid verwendet werden.

Werden Amine als Härtungsmittel verwendet, so werden diese normalerweise in 0,75 bis 1,25 Äquivalenten pro Epoxidäquivalent eingesetzt. Bei Polycarbonsäuren der deren Anhydriden werden 0,4 bis 1,1 Äquivalente pro Epoxidäquivalent verwendet.

Als Beschleuniger kommen vor allem Imidazolderivate, beispielsweise 2-Methylimidazol, 2-Phenylimidazol und 2-Heptadecylimidazol in Frage; weiterhin Phosphine, Metallseifen und Acetylacetonate.

Als Reaktiv-Verdünner kommen beispielsweise mono- oder polyfunktionelle, niedermolekulare Alkohole, die mit Epichlorhydrin umgesetzt werden, in Frage.

Durch Variation des Äquivalentverhältnisses von Polyepoxidverbindung zu Diphosphinsäure nach Formel (I) läßt sich der Phosphorgehalt des Produktes einstellen. Bevorzugt liegt das Äquivalentverhältnis zwischen 1: 0,1 und 1: 0,8 und besonders bevorzugt zwischen 1:0,1 und 1:0,4. Durch die Umsetzung des Epoxidharzes mit einer phosphorhaltigen Dicarbonsäure oder einem phosphorhaltigen Carbonsäureanhydrid wird ein noch schmelzbares und/oder lösliches, phosphormodifiziertes Epoxidharz erhalten, welches lagerstabil, wahlweise auch in Lösung, und einfach zu handhaben ist. In dem zweiten Reaktionsschritt wird dieses dann mit einem geeigneten Härter in die flammwidrige Epoxidharzmischung überführt.

Bevorzugt sind die flammwidrigen Epoxidharzmischungen durch Glasgewebe oder Glasfasern verstärkt. Sie können auch mit Füllstoffen wie Quarzmehl oder Aluminiumoxidhydrat ausgerüstet werden.

Die Erfindung betrifft ebenfalls die Verwendung der erfindungsgemäßen flammwidrigen Epoxidharzmischungen oder hergestellt nach dem erfindunggemäßen Verfahren in Beschichtungsmaterialien.

Die Erfindung betrifft auch Prepregs und Verbundwerkstoffe auf der Basis von anorganischen oder organischen Verstärkungsmaterialien in der Form von Fasern, Vliesen oder Geweben, hergestellt aus den erfindungsgemäßen Epoxidharzmischungen.

Die Erfindung betrifft schließlich auch Leiterplatten aus Prepregs, hergestellt aus Glasfasergeweben und den erfindungsgemäßen Epoxidharzmischungen.

Nachfolgend wird die Erfindung durch Beispiele erläutert. In den Beispielen wurde eine Phosphorverbindung nach Formel (IV) verwendet:

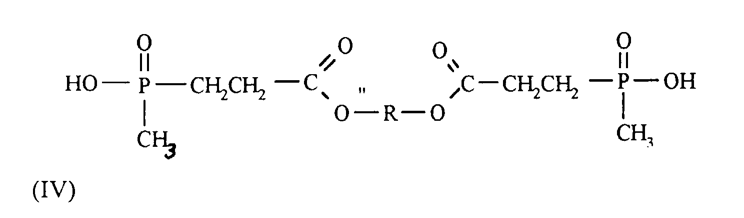

### Beispiel 1

In einem 500 ml Fünfhalskolben mit Rührerwelle, Tropftrichter, Rückflußkühler und Thermometer werden 147 g eines Bisphenol A-bisglycidylethers mit einem Epoxidwert von 0,55 mol/100 g und 54 g 2-Methyl-2,5-dioxo-1,2-oxaphospholan (0,4 mol) vorgelegt und unter Rühren auf 110 °C erwärmt. Während 30 min werden 12,6 g Ethylenglycol (0,2 mol) bei 110 °C zugetropft Nach weiteren 30 min Rühren bei 110 °C wird eine klare Lösung erhalten. Es wird noch 2 h bei dieser Temperatur und eine Stunde bei 130 °C gerührt. Man erhält ein farbloses, bei Raumtemperatur festes Epoxidharz mit einem Epoxidwert von 0,16 mol/100g und einem Phosphorgehalt von 5,7 Gew.-%.

### Beispiel 2

In einem 500 ml Fünfhalskolben mit Rührerwelle, Tropftrichter, Rückflußkühler und Thermometer werden 147 g eines Bisphenol A-bisglycidylethers mit einem Epoxidwert von 0,55 mol/100 g und 54 g 2-Methyl-2,5-dioxo-1,2-oxaphospholan (0,4 mol) in 54 ml Methylethylketon vorgelegt und unter Rühren auf 80 °C erwärmt. Während 30 min werden 12,6 g Ethylenglycol (0,2 mol) zugetropft. Nach weiteren 30 min Rühren wird eine klare Lösung erhalten. Es wird noch 5 h bei 80 °C gerührt. Man erhält eine 80%ige Lösung eines farblosen Epoxidharzes mit einem Epoxidwert von 0,13 mol/100g und einem Phosphorgehalt von 4,6 Gew.-%.

### Beispiel 3

In einem 500 ml Fünfhalskolben mit Rührerwelle, Tropftrichter, Rückflußkühler und Thermometer werden 124 g eines Bisphenol A-bisglycidylethers mit einem Epoxidwert von 0,55 mol/100 g und 46 g 2-Methyl-2,5-dioxo-1,2-oxaphospholan (0,34 mol) vorgelegt und unter Rühren auf 110 °C erwärmt. Während 30 min werden 12,9 g 1,3-Propandiol (0,17 mol) bei 110 °C zugetropft. Nach weiteren 30 min Rühren bei 110 °C wird eine klare Lösung erhalten. Es wird noch 2 h bei dieser Temperatur und eine Stunde bei 130 °C gerührt. Man erhält ein farbloses, bei Raumtemperatur festes Epoxidharz mit einem Epoxidwert von 0,19 mol/100g und einem Phosphorgehalt von 5,8 Gew.-%.

### Beispiel 4

In einem 500 ml Fünfhalskolben mit Rührerwelle, Tropftrichter, Rückflußkühler und Thermometer werden 123 g eines Bisphenol A-bisglycidylethers mit einem Epoxidwert von 0,55 mol/100 g und 45 g 2-Methyl-2,5-dioxo-1,2-oxaphospholan (0,34 mol) vorgelegt und unter Rühren auf 110 °C erwärmt. Während 30 min werden 18 g Diethylenglycol (0,17 mol) bei 110 °C zugetropft. Nach weiteren 30 min Rühren bei 110 °C wird eine klare Lösung erhalten. Es wird noch 2 h bei dieser Temperatur und eine Stunde bei 130 °C gerührt. Man erhält ein farbloses, bei Raumtemperatur festes Epoxidharz mit einem Epoxidwert von 0,21 mol/100g und einem Phosphorgehalt von 5,6 Gew.-%.

### Beispiel 5

In einem 500 ml Fünfhalskolben mit Rührerwelle, Tropftrichter, Rückflußkühler und Thermometer werden 102 g eines Bisphenol A-bisglycidylethers mit einem Epoxidwert von 0,55 mol/100 g und 38 g 2-Methyl-2,5-dioxo-1,2-oxaphospholan (0,28 mol) vorgelegt und unter Rühren auf 110 °C erwärmt. Anschließend werden 15,5 g Hydrochinon (0,14 mol) dazugegeben. Nach 30 min Rühren bei 110 °C wird eine klare Lösung erhalten. Es wird noch 2 h bei dieser Temperatur und eine Stunde bei 130 °C gerührt. Man erhält ein farbloses, bei Raumtemperatur festes Epoxidharz mit einem Epoxidwert von 0,21 mol/100g und einem Phosphorgehalt von 5,6 Gew.-%.

### Beispiel 6

In einem 500 ml Fünfhalskolben mit Rührerwelle, Tropftrichter, Rückflußkühler und Thermometer werden 102 g eines Bisphenol A-bisglycidylethers mit einem Epoxidwert von 0,55 mol/100 g und 38 g 2-Methyl-2,5-dioxo-1,2-oxaphospholan (0,28 vorgelegt und unter Rühren auf 110 °C erwärmt. Anschließend werden 15,5 g Resorcin (0,14 mol) dazugegeben. Nach 30 min Rühren bei 110 °C wird eine klare Lösung erhalten. Es wird noch 2 h bei dieser Temperatur und eine Stunde bei 130 °C gerührt. Man erhält ein farbloses, bei Raumtemperatur festes Epoxidharz mit einem Epoxidwert von 0,19 mol/100g und einem Phosphorgehalt von 5,6 Gew.-%.

### Beispiel 7

100 g phoshormodifiziertes Epoxidharz nach Beispiel 1 werden bei 120 °C aufgeschmolzen und mit 3,1 g mikronisiertem Dicyandiamid (®Dyhard 100 SF, SKW Trostberg AG) und 0,3 g Imidazol-Beschleuniger (®Dyhard MI, SKW Trostberg AG) intensiv vermischt und in einer Teflonform von 200x200x2 mm im Trockenschrank bei 150 - 180 °C während 4 h ausgehärtet. Aus dieser Formmasse wurden Prüfkörper von 127 mm Länge und 12,7 mm Breite gesägt.

### Beispiel 8

100 g phosphormodifiziertes Epoxidharz nach Beispiel 2 werden bei 120 °C aufgeschmolzen und mit 22 g Methylcyclohexandicarbonsäureanhydrid und 0,4 g Benzyldimethylamin intensiv vermischt und in einer Teflonform von 200x200x2 mm im Trockenschrank bei 120 - 180 °C während 4 h ausgehärtet. Aus dieser Formmasse wurden Prüfkörper von 127 mm Länge und 12,7 mm Breite gesägt.

### Beispiel 9

120 g phoshormodifiziertes Epoxidharz nach Beispiel 6 werden bei 120 °C aufgeschmolzen und mit 3,3 g mikronisiertem Dicyandiamid (®Dyhard 100 SF, SKW Trostberg AG) und 0,3 g Imidazol-Beschleuniger (®Dyhard MI, SKW Trostberg AG) intensiv vermischt und in einer Teflonform von 200x200x2 mm im Trockenschrank bei 150 - 180 °C während 4 h ausgehärtet. Aus dieser Formmasse wurden Prüfkörper von 127 mm Länge und 12,7 mm Breite gesägt.

### Beispiel 10

100 g phosphormodifiziertes Epoxidharz nach Beispiel 7 werden bei 120 °C aufgeschmolzen und mit 25 g Methylcyclohexandicarbonsäureanhydrid und 0,4 g Benzyldimethylamin intensiv vermischt und in einer Teflonform von 200x200x2 mm im Trockenschrank bei 120 - 180 °C während 4 h ausgehärtet. Aus dieser Formmasse wurden Prüfkörper von 127 mm Länge und 12,7 mm Breite gesägt.

### Beispiel 11 (Vergleichsbeispiel)

150 g eines Bisphenol-A-bisglycidylethers (®Beckopox EP 140) mit einem Epoxidwert von 0,53 mol/100g werden und mit 6,9 g mikronisiertem Dicyandiamid (®Dyhard 100 SF, SKW Trostberg AG) und 0,3 g Imidazol-Beschleuniger (®Dyhard MI, Methylimidazol, SKW Trostberg AG) intensiv vermischt und in einer Teflonform von 200x200x2 mm im Trockenschrank bei 150 - 180 °C während 4 h ausgehärtet. Aus dieser Formmasse wurden Prüfkörper von 127 mm Länge und 12,7 mm Breite gesägt.

Die Prüffing des Brandverhaltens wurde nach der Vorschrift von Underwriters Laboratories "Test for Flammability of Plastic Materials - UL 94" in der Fassung vom 02.05.1975 an Prüfkörpern von 127 mm Länge, 12,7 mm Breite und 2 mm Dicke durchgeführt. Der Sauerstoffindex wurde in einer Apparatur nach ASTM-D 2863-74 bestimmt.

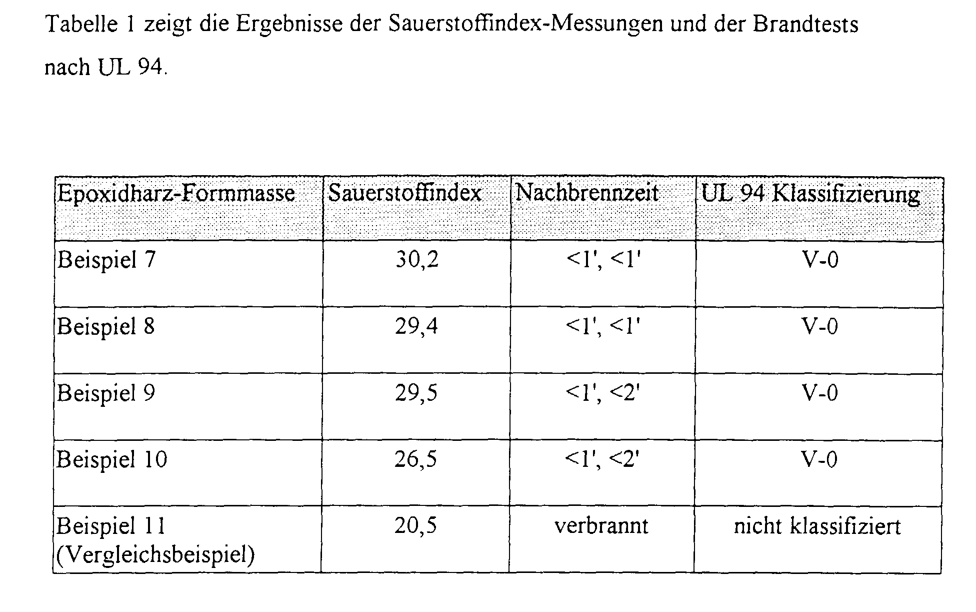

Die nachfolgenden Beispiele 12 bis 19 zeigen die weitere Ausgestaltung der erfindungsgemäßen Verfahren.

### Beispiel 12

134,1 g ( 1 mol) Oxaphospholan und 55 g Resorcin (0,5 mol) werden vermengt und auf 120 °C erhitzt. Es entsteht eine klare Lösung mit einer Säurezahl von 578 mg KOH/g. Nach 1 h Rühren bei 140 °C geht die Säurezahl auf 472 mg KOH/g zurück, nach weiteren 2,5 h Rühren bei 140 °C beträgt die Säurezahl nur noch 350 mg KOH/g. Das Produkt wird ausgegossen und nach Erkalten gemörsert.

### Beispiel 13

42,7 g Produkt aus Beispiel 12 und 150 g eines Bisphenol-A bisglycidylethers mit einem Epoxidwert von 0,55 mol/100 g werden vermischt und auf 130 °C erwärmt. Die Säurezahl der Mischung beträgt 80 mg KOH/g. Nach 15 min Rühren bei 130 °C beträgt die Säurezahl 20 mg KOH/g, nach 2 h Reaktionszeit wird bei einer Säurezahl von 4 mg KOH/g abgebrochen. Man erhält ein farbloses, bei Raumtemperatur festes Epoxidharz mit einem Epoxidwert von 0,29 mol/100 g und einem Phosphorgehalt von 3,5 %.

### Beispiel 14

26,8 g (0,2 mol) Oxaphospholan, 10 g Resorcin (0,1 mol) und 140 g eines Bisphenol-A bisglycidylethers mit einem Epoxidwert von 0,55 mol/100 g werden vermischt und auf 130 °C erwärmt. Die anfängliche Säurezahl der Mischung beträgt 127 mg KOH/g. Nach 60 min Rühren bei 100 °C beträgt die Säurezahl 68 mg KOH/g, nach 4 h Reaktionszeit wird bei einer Säurezahl von 9 mg KOH/g abgebrochen. Man erhält ein farbloses, bei Raumtemperatur festes Epoxidharz mit einem Epoxidwert von 0,31 mol/100 g und einem Phosphorgehalt von 3,5 %.

### Beispiel 15

134,1 g (1 mol) Oxaphospholan und 55 g Hydrochinon (0,5 mol) werden vermengt und auf 150 °C erhitzt. Nach 2 h Rühren bei 150 °C geht die Säurezahl auf 355 mg KOH/g zurück, nach weiteren 2,5 h Rühren bei 150 °C beträgt die Säurezahl 350 mg KOH/g. Das Produkt wird ausgegossen und nach Erkalten gemörsert.

### Beispiel 16

42,7 g Produkt aus Beispiel 15 und 150 g eines Bisphenol-A bisglycidylethers mit einem Epoxidwert von 0,55 mol/100 g werden vermischt und auf 130 °C erwärmt. Nach 2 h Reaktionszeit entsteht eine homogene Schmelze, nach weiteren 4 h Reaktionszeit bei 140-180 °C ist keine Säurezahl mehr meßbar. Man erhält ein farbloses, bei Raumtemperatur festes Epoxidharz mit einem Epoxidwert von 0,15 mol/100 g und einem Phosphorgehalt von 3,5 %.

### Beispiel 17

26,8 g (0,2 mol) Oxaphospholan, 10 g Hydrochinon (0,1 mol) und 140 g eines Bisphenyl-A bisglycidylethers mit einem Epoxidwert von 0,55 mol/100 g werden vermischt und auf 130 °C erwärmt. Die anfängliche Säurezahl der Mischung beträgt 127 mg KOH/g. Nach 60 min Rühren bei 100 °C beträgt die Säurezahl 70 mg KOH/g, nach 2,5 g 25 mg KOH/g und nach 4 h Reaktionszeit wird bei einer Säurezahl von 5 mg KOH/g abgebrochen. Man erhält ein farbloses, bei Raumtemperatur festes Epoxidharz mit einem Epoxidwert von 0,12 mol/ 100 g und einem Phosphorgehalt von 3,5 %.

### Beispiel 18

899,7 g (6,7 mol) Oxaphospholan und 208,3 g Ethylenglycol (3,355 mol) werden vermengt. Die Temperatur der Mischung steigt auf 50-60 °C. Nach weiteren 2 h Rühren bei 100 °C wird ein hellgelbes, bei etwa 50 °C erstarrendes Produkt erhalten. Die Säurezahl beträgt 340 mg KOH/g.

### Beispiel 19

50 g Produkt aus Beispiel 18 und 220 g eines Bisphenol-A bisglycidylethers mit einem Epoxidwert von 0,55 mol/100 g werden vermischt und auf 130 °C erwärmt. Nach 2 h Reaktionszeit entsteht eine homogene Schmelze, nach weiteren 2 h Reaktionszeit bei 140 °C ist keine Säurezahl mehr meßbar. Man erhält ein farbloses, bei Raumtemperatur festes Epoxidharz mit einem Epoxidwert von 0,2 mol/100 g und einem Phosphorgehalt von 3,5 %.

## Patentansprüche

1. Flammwidrige Epoxidharzmischung aus Epoxidharzen, phosphorhaltigen Verbindungen und einem Härter, dadurch gekennzeichnet, daß sie phosphorhaltige Struktureinheiten der Formel I 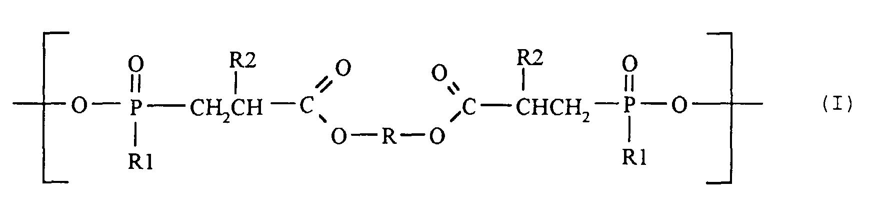 in der R1 eine Alkyl- oder Arylgruppe mit 1 bis 10 C-Atomen, R2 Wasserstoff oder eine Alkylgruppe mit 1 bis 4 C-Atomen und R eine Alkylen-, Cycloalkylen- oder Arylengruppe mit 2 bis 20 C-Atomen bedeutet, enthält.

2. Flammwidrige Epoxidharzmischung nach Anspruch 1, dadurch gekennzeichnet, daß sie auf 100 Gewichtsteile Epoxidharz 10 bis 100 Gewichtsteile phosphorhaltige Struktureinheiten der Formel I enthält und das Gesamtgewichtsverhältnis von Epoxidharz und phosphorhaltiger Struktureinheit nach Formel I zu Härter (1 bis 10) zu 1 beträgt.

3. Flammwidrige Epoxidharzmischung nach Anspruch 1 oder 2, dadurch gekennzeichnet, daß sie halogenfrei ist.

4. Flammwidrige Epoxidharzmischung nach einem oder mehreren der Ansprüche 1 bis 3, dadurch gekennzeichnet, daß sie 5 bis 300 Gewichtsteile an phosphorfreien Epoxidharzen enthält.

5. Flammwidrige Epoxidharzmischung nach einem oder mehreren der Ansprüche 1 bis 4, dadurch gekennzeichnet, daß sie 5 bis 300 Gewichtsteile an weiteren Inhalts- und/oder Füllstoffen enthält.

6. Flammwidrige Epoxidharzmischung nach einem oder mehreren der Ansprüche 1 bis 5, dadurch gekennzeichnet, daß sie 0,5 bis 13 Gew.-% Phosphor, bezogen auf das Gesamtgewicht der flammwidrigen Epoxidharzmischung, enthält.

7. Flammwidrige Epoxidharzmischung nach einem oder mehreren der Ansprüche 1 bis 5, dadurch gekennzeichnet, daß sie 1 bis 6 Gew.-% Phosphor, bezogen auf das Gesamtgewicht der flammwidrigen Epoxidharzmischung, enthält.

8. Flammwidrige Epoxidharzmischung nach einem oder mehreren der Ansprüche 1 bis 7, dadurch gekennzeichnet, daß sie einen Beschleuniger enthält.

9. Verfahren zur Herstellung von flammwidrigen Epoxidharzmischungen aus Epoxidharzen, phosphorhaltigen Verbindungen und einem Härter, dadurch gekennzeichnet, daß man
a) in einem ersten Reaktionsschritt eine Polyepoxidverbindung mit mindestens 2 Epoxidgruppen pro Molekül und ein 2,5-Dioxo-1,2-oxa-phospholan der allgemeinen Formel II 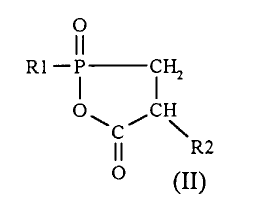 worin R1 und R2 die gleiche Bedeutung wie in Formel I haben, miteinander erwärmt, bis eine homogene Schmelze entstanden ist und
b) in einem zweiten Reaktionsschritt zu der Schmelze ein Diol der allgemeinen Formel HO - R - OH, worin R die gleiche Bedeutung wie in Formel I hat, zugibt, wobei
c) in einem dritten Reaktionsschritt aus dem 2,5-Dioxo-1,2-oxa-phospholan der homogenen Schmelze und dem dazugegebenen Diol HO - R - OH eine Diphosphinsäure der allgemeinen Formel III entsteht, welche direkt in die Polyepoxidverbindung einreagiert.

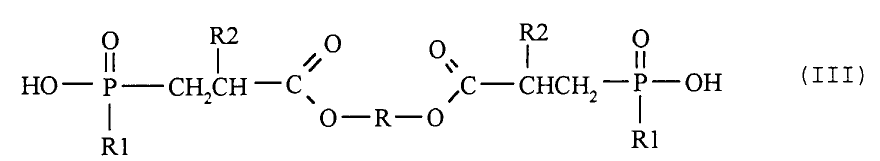

10. Verfahren zur Herstellung von flammwidrigen Epoxidharzmischungen aus Epoxidharzen, phosphorhaltigen Verbindungen und einem Härter, dadurch gekennzeichnet, daß man
a) in einem ersten Reaktionsschritt ein 2,5-Dioxo-1,2-oxa-phospholan der allgemeinen Formel II mit einem Diol der allgemeinen Formel HO - R - OH, worin R die gleiche Bedeutung wie in Formel I hat, umsetzt, wobei eine Diphosphinsäure der allgemeinen Formel III entsteht, und dann
b) in einem zweiten Reaktionsschritt die Diphosphinsäure mit einer Polyepoxidverbindung mit zumindest zwei Epoxidgruppen pro Molekül umsetzt.

11. Verfahren nach Anspruch 9 oder 10, dadurch gekennzeichnet, daß die Umsetzungen in einem Lösungsmittel erfolgen.

12. Verfahren nach Anspruch 11, dadurch gekennzeichnet, daß aprotische, polare Lösungsmittel, wie N-methylpyrrolidon, Dimethylformamid, Tetrahydrofuran, Dioxan, Dialkylether, Glykolether, Ketone und/oder Ester eingesetzt werden.

13. Verfahren nach Anspruch 11, dadurch gekennzeichnet, daß als Lösungsmittel halogenierte Kohlenwasserstoffe, aliphatische, cycloaliphatische und/oder aromatische Kohlenwasserstoffe, einzeln oder als Gemische, eingesetzt werden.

14. Verfahren nach einem oder mehreren der Ansprüche 9 bis 13, dadurch gekennzeichnet, daß die Umsetzungen bei Temperaturen zwischen -10 bis +200 °C erfolgen.

15. Verfahren nach Anspruch 14, dadurch gekennzeichnet, daß die Umsetzungen bei Temperaturen von 70 bis 130 °C erfolgen.

16. Verwendung von Epoxidharzmischungen nach einem oder mehreren der Ansprüche 1 bis 8 oder hergestellt nach einem oder mehreren der Ansprüche 9 bis 15 in Beschichtungsmaterialien.

17. Prepregs und Verbundwerkstoffe auf der Basis von anorganischen oder organischen Verstärkungsmaterialien in der Form von Fasern, Vliesen oder Geweben, hergestellt aus Epoxidharzmischungen nach einem oder mehreren der Ansprüche 1 bis 8 oder erhalten nach dem Verfahren gemäß einem oder mehreren der Ansprüche 9 bis 15.

18. Leiterplatten aus Prepregs, hergestellt aus Glasfasergeweben und Epoxidharzmischungen nach einem oder mehreren der Ansprüche 1 bis 8 oder erhalten nach dem Verfahren gemäß einem oder mehreren der Ansprüche 9 bis 15.

## Claims

1. A flame-resistant epoxy resin mixture comprising epoxy resins, phosphorus-containing compounds and a curing agent, wherein the epoxy resin mixture comprises phosphorus-containing structural units of the formula I 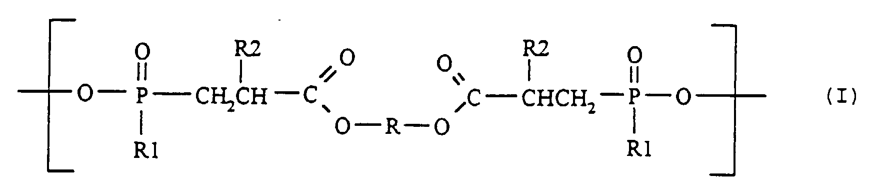 in which R1 is an alkyl or aryl group having from 1 to 10 carbon atoms, R2 is hydrogen or an alkyl group having from 1 to 4 carbon atoms and R is an alkylene, cycloalkylene or arylene group having from 2 to 20 carbon atoms.

2. A flame-resistant epoxy resin mixture as claimed in claim 1, wherein the epoxy resin mixture comprises from 10 to 100 parts by weight of a phosphorus-containing structural unit of the formula I per 100 parts by weight of epoxy resin, the total weight ratio of epoxy resin and phosphorus-containing structured unit of formula I to curing agent being from 1:1 to 10:1.

3. A flame-resistant epoxy resin mixture as claimed in claim 1 or 2, wherein the epoxy resin mixture is halogen-free.

4. A flame-resistant epoxy resin mixture as claimed in one or more of claims 1 to 3, wherein the epoxy resin mixture includes from 5 to 300 parts by weight of phosphorus-free epoxy resins.

5. A flame-resistant epoxy resin mixture as claimed in one or more of claims 1 to 4, wherein the epoxy resin mixture includes from 5 to 300 parts by weight of other ingredients and/or fillers.

6. A flame-resistant epoxy resin mixture as claimed in one or more of claims 1 to 5, wherein the epoxy resin mixture includes from 0.5 to 13 % by weight of phosphorus, based on the total weight of the flame-resistant epoxy resin mixture.

7. A flame-resistant epoxy resin mixture as claimed in one or more of claims 1 to 5, wherein the epoxy resin mixture includes from 1 to 6 % by weight of phosphorus, based on the total weight of the flame-resistant epoxy resin mixture.

8. A flame-resistant epoxy resin mixture as claimed in one or more of claims 1 to 7, wherein the epoxy resin mixture includes an accelerator.

9. A process for producing flame-resistant epoxy resin mixtures from epoxy resins, phosphorus-containing compounds and a curing agent, which comprises
a) in a first reaction step, heating a polyepoxide compound having at least 2 epoxide groups per molecule together with a 2,5-dioxo-1,2-oxaphospholane of the formula II 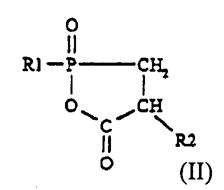 where R1 and R2 are as defined in formula I, until a homogeneous melt is produced, and
b) in a second reaction step, adding a diol of the formula HO - R - OH, where R is as defined in formula I, to the melt, and
c) in a third reaction step, forming from the 2,5-dioxo-1,2-oxaphospholane in the homogeneous melt and the added diol HO - R - OH a diphosphinic acid of the formula III, which reacts directly with the polyepoxide compound.

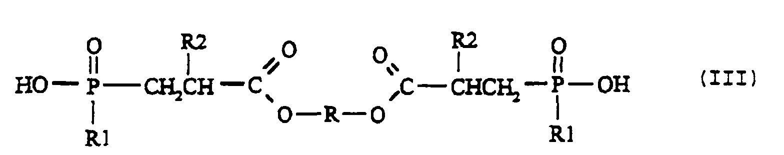

10. A process for producing flame-resistant epoxy resin mixtures from epoxy resins, phosphorus-containing compounds and a curing agent, which comprises
a) in a first reaction step, reacting a 2,5-dioxo-1,2-oxaphospholane of the formula II with a diol of the formula HO - R - OH, where R is as defined in formula I, giving a diphosphinic acid of the formula III, and then
b) in a second reaction step, reacting the diphosphinic acid with a polyepoxide compound having at least two epoxide groups per molecule.

11. The process as claimed in claim 9 or 10, wherein the reactions are carried out in a solvent.

12. The process as claimed in claim 11, wherein aprotic, polar solvents, such as N-methylpyrrolidone, dimethylformamide, tetrahydrofuran, dioxane, dialkyl ethers, glycol ethers, ketones and/or esters, are employed.

13. The process as claimed in claim 11, wherein halogenated hydrocarbons or aliphatic, cycloaliphatic and/or aromatic hydrocarbons, individually or as mixtures, are employed as solvent.

14. The process as claimed in one or more of claims 9 to 13, wherein the reactions are carried out at temperatures between -10 and +200EC.

15. The process as claimed in claim 14, wherein the reactions are carried out at temperatures from 70 to 130EC.

16. A method of using epoxy resin mixtures as claimed in one or more of claims 1 to 8, or produced- as claimed in one or more of claims 9 to 15, in coating materials.

17. A prepreg and a composite material based on inorganic or organic reinforcing materials in the form of fibers, webs or fabrics and produced from epoxy resin mixtures as claimed in one or more of claims 1 to 8 or obtained by the process as claimed in one or more of claims 9 to 15.

18. A printed circuit board made from a prepreg produced from glass-fiber fabrics and epoxy resin mixtures as claimed in one or more of claims 1 to 8 or obtained by the process as claimed in one or more of claims 9 to 15.

## Revendications

1. Mélange ignifuge de résines époxydes constitué par des résines époxydes, des composés phosphorés et d'un durcisseur, caractérisé en ce qu'il comporte des unités de structure phosphorées de formule I 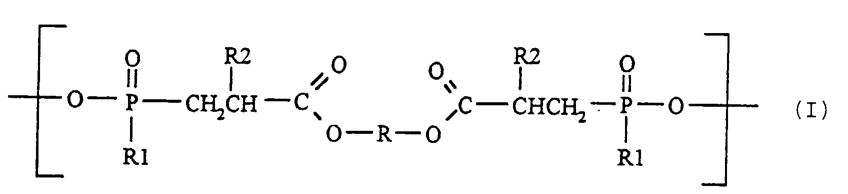 dans laquelle R1 représente un groupe alkyle ou aryle comportant de 1 à 10 atomes de carbone, R2 représente un atome d'hydrogène ou un groupe alkyle comportant 1 à 4 atomes de carbone et R représente un groupe alkylène, cycloalkylène ou arylène comportant 2 à 20 atomes de carbone.

2. Mélange ignifuge de résines époxydes selon la revendication 1, caractérisé en ce qu'il contient de 10 à 100 parties en masse d'unités de structure phosphorées de formule I pour 100 parties en masse de résine époxyde et le rapport pondéral total de la résine époxyde et de l'unité de structure phosphorée de formule I au durcisseur est de (1 à 10) à 1.

3. Mélange ignifuge de résines époxydes selon la revendication 1 ou 2, caractérisé en ce qu'il est exempt d'halogènes.

4. Mélange ignifuge de résines époxydes selon une ou plusieurs des revendications 1 à 3, caractérisé en ce qu'il présente une teneur de 5 à 300 parties en masse en résines époxydes exemptes de phosphore.

5. Mélange ignifuge de résines époxydes selon une ou plusieurs des revendications 1 à 4, caractérisé en ce qu'il présente une teneur de 5 à 300 parties en masse en autres matières d'addition et/ou charges.

6. Mélange ignifuge de résines époxydes selon une ou plusieurs des revendications 1 à 5, caractérisé en ce qu'il présente une teneur de 0,5 à 13% en masse en phosphore par rapport au poids total du mélange ignifuge de résines époxydes.

7. Mélange ignifuge de résines époxydes selon une ou plusieurs des revendications 1 à 5, caractérisé en ce qu'il présente une teneur de 1 à 6% en masse en phosphore par rapport au poids total du mélange ignifuge de résines époxydes.

8. Mélange ignifuge de résines époxydes selon une ou plusieurs des revendications 1 à 7, caractérisé en ce qu'il contient un accélérateur.

9. Procédé de préparation d'un mélange ignifuge de résines époxydes à partir de résines époxydes, de composés phosphorés et d'un durcisseur, caractérisé en ce que
a) dans une première étape réactionnelle, on chauffe un composé polyépoxyde comportant au moins 2 groupes époxydes par molécule et un 2,5-dioxo-1,2-oxa-phospholane de formule générale II 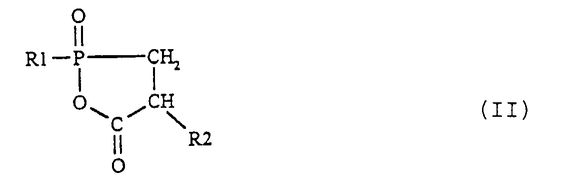 où R1 et R2 possèdent les mêmes significations qu'à la formule I, jusqu'à l'obtention d'une matière fondue homogène et
b) dans une deuxième étape réactionnelle, on ajoute à la matière fondue un diol de formule générale HO-R-OH, où R possède la même signification qu'à la formule I, en obtenant
c) dans une troisième étape réactionnelle, à partir de la matière fondue homogène de 2,5-dioxo-1,2-oxa-phospholane et du diol HO-R-OH ajouté, un acide diphosphinique de formule générale III, lequel réagit directement en donnant le composé polyépoxyde

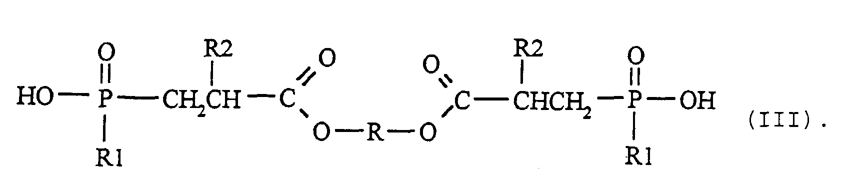

10. Procédé de préparation de mélanges ignifuges de résines époxydes à partir de résines époxydes, de composés phosphorés et d'un durcisseur, caractérisé en ce que
a) dans une première étape réactionnelle, on fait réagir un 2,5-dioxo-1,2-oxa-phospholane de formule générale II avec un diol de formule générale
HO-R-OH, où R possède la même signification qu'à la formule I, ce qui donne un acide diphosphinique de formule générale III, et ensuite
b) dans une deuxième étape réactionnelle, on fait réagir l'acide diphosphinique avec un composé polyépoxyde présentant au moins deux groupes époxydes par molécule.

11. Procédé selon la revendication 9 ou 10, caractérisé en ce que l'on met en oeuvre la réaction en milieu d'un solvant.

12. Procédé selon la revendication 11, caractérisé en ce qu'on utilise des solvants aprotiques polaires comme la N-méthylpyrrolidone, le diméthylformamide, le tétra-hydrofuranne, le dioxanne, un éther dialkylique, des éthers de glycol, des cétones et/ou esters.

13. Procédé selon la revendication 11, caractérisé en ce qu'on utilise comme solvant des hydrocarbures halogénés, des hydrocarbures aliphatiques, cycloaliphatiques et/ou aromatiques, seuls ou en mélange.

14. Procédé selon une ou plusieurs des revendications 9 à 13, caractérisé en ce qu'on met en oeuvre la réaction à une température comprise entre -10 et +200°C.

15. Procédé selon la revendication 14, caractérisé en ce qu'on met en oeuvre la réaction à une température de 70 à 130°C.

16. Utilisation de mélanges de résines époxydes selon une ou plusieurs des revendications 1 à 8 ou préparés selon une ou plusieurs des revendications 9 à 15 dans des matériaux de revêtement.

17. Préimprégnés ou matériaux composites à base de matières de renfort organiques ou inorganiques sous forme de fibres, de nappes ou de tissus, préparés à partir des mélanges de résines époxydes selon une ou plusieurs des revendications 1 à 8 ou obtenus au moyen du procédé selon une ou plusieurs des revendications 9 à 15.

18. Circuits imprimés en préimprégnés préparés à partir de fibres de verre et de mélanges de résines époxydes selon une ou plusieurs des revendications 1 à 8 ou obtenus au moyen du procédé selon une ou plusieurs des revendications 9 à 15.
